# EUROPEAN PATENT APPLICATION

(11) **EP 4 557 359 A1**
(43) Date of publication of application: **21.05.2025**
(21) Application number: 24210497.4
(22) Date of filing: 04.11.2024
(51) Int. Cl.: H01L 23/31, H01L 25/16, H01L 23/498, H01L 25/10, H01Q 3/00

(54) **ENABLING MM-WAVE AESAS USING ADVANCED PACKAGING**

(30) Priority: 20.11.2023 US 202318514503
(71) Applicant: Rockwell Collins, Inc., Cedar Rapids, IA 52498 (US)
(72) Inventor: MAYFIELD, James B., Cedar Rapids, IA (US); MAINS, Neal D., Marion, IA (US); TAWNEY, Russell C., Cedar Rapids, IA (US)
(74) Representative: Dehns

(57) **Abstract**

A package includes a die (100) and a plurality of electronic components disposed on a top surface of the package, connected to the die (100) by vias. The die (100) may be encased in an over mold, with the vias transiting through the over mold. The die (100) may be connected to an interposer through the over mold. The interposer may be affixed to a host circuit board. Electronic components may be affixed to the top surface of the package and reflowed after the die (100) is encapsulated. Electronic components may be selected or tuned according to specific applications. The interposer may be at least partially encapsulated in the over mold, and one or more electronic components may be disposed on the top surface and in direct electronic communication with the interposer through corresponding vias.

## Description

### BACKGROUND

Active electronically scanned array (AESA) antennas are progressing to smaller and smaller unit cell sizes and antenna element sizes at high frequencies (mmWave bands). Such small unit cell sizes provide limited space for necessary components. Frequency of operation defines lattice spacing and therefore creates the available envelope. As frequencies trend higher and higher, these issues continue to grow. High frequency operation requires power supply decoupling capacitors to be as close to the beamformer or amplifier die as possible.

Furthermore, existing and upcoming applications require high capacitance for pulsed applications, precision calibration resistors, multiple semiconductor technologies for specific integrated circuits to enable specific functions and provide optimal performance. If high capacitance or other components, which are not producible on the die, are required to support the functionality, there is minimal room for these components with an antenna layer on the bottom and large die on the top.

Large dies require extremely flat, well balanced printed circuit boards to obtain proper solder joint connections. Differences in coefficient of thermal expansion of silicon versus the printed circuit boards over large distances cause solder joints to fail.

Also, electronic components may be packaged with a die inside of an encapsulated beamformer or amplifier package. Once devices are encapsulated together and there is a failure of that packaged device, an entire LGA or BGA packaged amplifier or beamformer would need to be scrapped and replaced.

### SUMMARY

In one aspect, embodiments of the inventive concepts disclosed herein are directed to a package including a die and a plurality of electronic components disposed on a top surface of the package, connected to the die by metal structures such as vias. In general, the term via represents an interconnect connecting adjacent conductive layers. While typically vertical in nature and perpendicular to the two adjacent layers, this is not a requirement. The die may be encased in an over mold, with the vias transiting through the over mold.

In a further aspect, components may be directly connected to the die.

In a further aspect, the die may be connected to an interposer through the over mold. The interposer may be affixed to a host circuit board.

In a further aspect, electronic components may be affixed to the top surface of the package and reflowed after the die is encapsulated. Electronic components may be selected or tuned according to specific applications.

In a further aspect, the interposer may be at least partially encapsulated in the over mold, and one or more electronic components may be disposed on the top surface and in direct electronic communication with the interposer through corresponding vias.

**The** present disclosure enables microelectronics packaging to allow more efficient use of volume on an AESA assembly while minimizing both the size and number of PCBs that need to be designed.

It is to be understood that both the foregoing general description and the following detailed description are exemplary and explanatory only and should not restrict the scope of the claims. The accompanying drawings, which are incorporated in and constitute a part of the specification, illustrate exemplary embodiments of the inventive concepts disclosed herein and together with the general description, serve to explain the principles.

### BRIEF DESCRIPTION OF THE DRAWINGS

The numerous advantages of the embodiments of the inventive concepts disclosed herein may be better understood by those skilled in the art by reference to the accompanying figures in which:
FIG. 1 shows a side view block diagram of a unit cell according to an exemplary embodiment;
FIG. 2 shows a side view block diagram of a unit cell according to an exemplary embodiment;
FIG. 3 shows a side view block diagram of a unit cell according to an exemplary embodiment;

### DETAILED DESCRIPTION

Before explaining various embodiments of the inventive concepts disclosed herein in detail, it is to be understood that the inventive concepts are not limited in their application to the arrangement of the components or steps or methodologies set forth in the following description or illustrated in the drawings. In the following detailed description of embodiments of the instant inventive concepts, numerous specific details are set forth in order to provide a more thorough understanding of the inventive concepts. However, it will be apparent to one of ordinary skill in the art having the benefit of the instant disclosure that the inventive concepts disclosed herein may be practiced without these specific details. In other instances, well-known features may not be described in detail to avoid unnecessarily complicating the instant disclosure. The inventive concepts disclosed herein are capable of other embodiments or of being practiced or carried out in various ways. Also, it is to be understood that the phraseology and terminology employed herein is for the purpose of description and should not be regarded as limiting.

**As** used herein a letter following a reference numeral is intended to reference an embodiment of a feature or element that may be similar, but not necessarily identical, to a previously described element or feature bearing the same reference numeral (e.g., 1, 1a, 1b). Such shorthand notations are used for purposes of convenience only, and should not be construed to limit the inventive concepts disclosed herein in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" are employed to describe elements and components of embodiments of the instant inventive concepts. This is done merely for convenience and to give a general sense of the inventive concepts, and "a" and "an" are intended to include one or at least one and the singular also includes the plural unless it is obvious that it is meant otherwise.

Also, while various components may be depicted as being connected directly, direct connection is not a requirement. Components may be in electronic communication with intervening components that are not illustrated or described.

Finally, as used herein any reference to "one embodiment," or "some embodiments" means that a particular element, feature, structure, or characteristic described in connection with the embodiment is included in at least one embodiment of the inventive concepts disclosed herein. The appearances of the phrase "in at least one embodiment" in the specification does not necessarily refer to the same embodiment. Embodiments of the inventive concepts disclosed may include one or more of the features expressly described or inherently present herein, or any combination or sub-combination of two or more such features.

Broadly, embodiments of the inventive concepts disclosed herein are directed to a package including a die and a plurality of electronic components disposed on a top surface of the package, connected to the die by vias. The die may be encased in an over mold, with the vias transiting through the over mold. The die may be connected to an interposer within the over mold. The interposer may be affixed to a host circuit board. Electronic components may be affixed to the top surface of the package and reflowed after the die is encapsulated. Electronic components may be selected or tuned according to specific applications. The interposer may be at least partially encapsulated in the over mold, and one or more electronic components may be disposed on the top surface and in direct electronic communication with the interposer through corresponding vias.

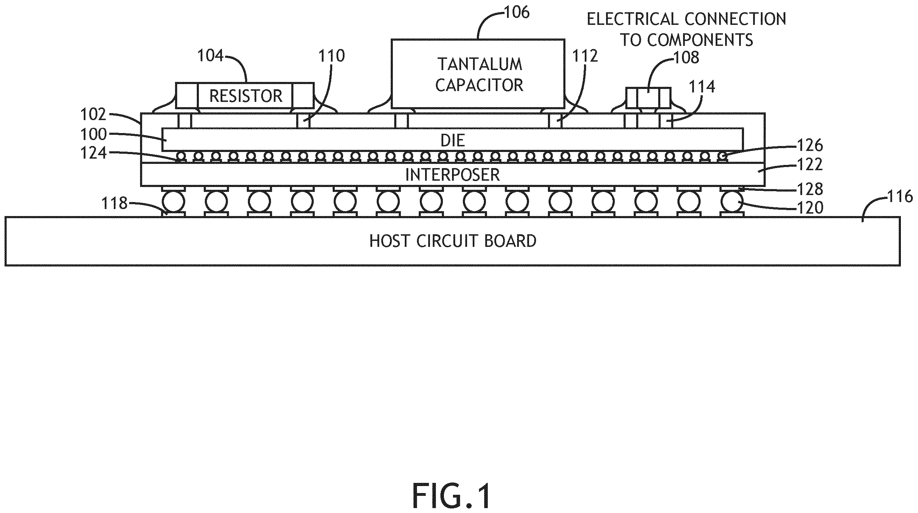

Referring to FIG. 1, a side view block diagram of a unit cell according to an exemplary embodiment is shown. In at least one embodiment, a die 100 contained within an over mold 102 of plastic or other inert material. The die 100 is in electronic communication with electronic components 104, 106, 108 disposed on a top surface of the die 100 / over mold 102. Each electronic component 104, 106, 108 is connected to a top surface of the die 100 by corresponding metal structure 110, 112, 114 such as a via. The electronic components 104, 106, 108 may comprise resistors 104, tantalum or ceramic capacitors 106, 108, voltage regulators, power supplies, or the like.

In at least one embodiment, the die 100 may be configured to receive electronic components 104, 106, 108 with some range of component parameters. The electronic components 104, 106, 108 are not necessarily part of a production package and may be tunable for specific applications or hardware. Electronic components 104, 106, 108 may be applied and reflowed prior to cutting the over molded panels into individual beamformer or amplifier components. Soldering techniques allow electronic components 104, 106, 108 to be reflowed. Furthermore, production tools may be used to rework the electronic components on the top of the packaged beamformer or amplifier before or after it has been placed on the host AESA board. It may be appreciated that other attachment methods may exist for components such as certain electrically conductive adhesives; such attachment methods are envisioned for embodiments of the present disclosure.

In at least one embodiment, the die 100 / over mold 102, and corresponding electronic components 104, 106, 108 may be disposed on a circuit board 116. The circuit board 116 may define a plurality of pads 118; the pads 118 may receive solder 120 during a mounting process to create electronic connectivity between the circuit board 116 and the die 100. By mounting electronic components 104, 106, 108 above the die, circuit board area around amplifiers or beamformers may remain free from components to support BGA / LGA rework processes. In at least one embodiment, the die 100 / over mold 102 may be disposed on an interposer 122. The interposer 122 includes top pads 124 disposed to engage solder 126 to create electronic connectivity with the die 100 at a top surface, and bottom pads 128 disposed to engage the solder 120 to create electronic connectivity with the circuit board 116. Vias create electronic connectivity between the top pads 124 and bottom pads 128 within the interposer 122.

Alternatively, or in addition, embodiments of the present disclosure may be embodied in electronic packages such as lead frame packaging or other substrate-less technologies such as wafer level chip scale packaging (WLCSP) or wafer level fanout (WLFO).

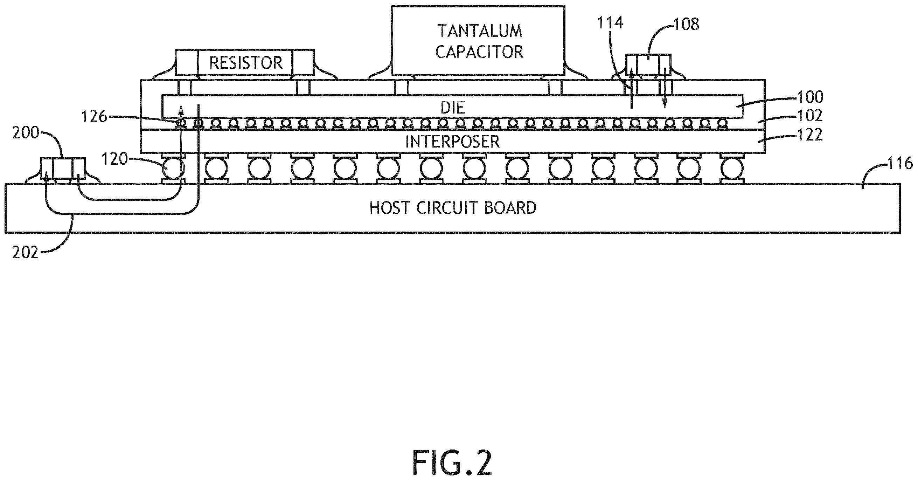

Referring to FIG. 2, a side view block diagram of a unit cell according to an exemplary embodiment is shown. Traditional architecture includes electronic components 200, such as resistors, capacitors, or the like, disposed on the circuit board 116. Such electronic components 200 must be in electronic communication with a die 100 via solder 120 connections between the circuit board 116 and an interposer 122, and solder 126 connections between the interposer 122 and the die 100. Such architecture necessarily produces large loop areas 202 with high impedance and large EMI coupling or emission regions.

Embodiments of the present disclosure include electronic components 108 disposed on a top surface of the die 100 / over mold 102 with direct vias 114 to the die 100. Such architecture produces smaller loop area with low inductance and smaller EMI coupling or emission regions. In one aspect, the shorter length of the loop area is advantageous to reduce inductance and EMI coupling; furthermore, the orientation of the loop area (entirely orthogonal to the die 100 as compared to partially parallel to the die 100) may also reduce inductance and EMI coupling, especially in high frequency applications (e.g., K band or higher).

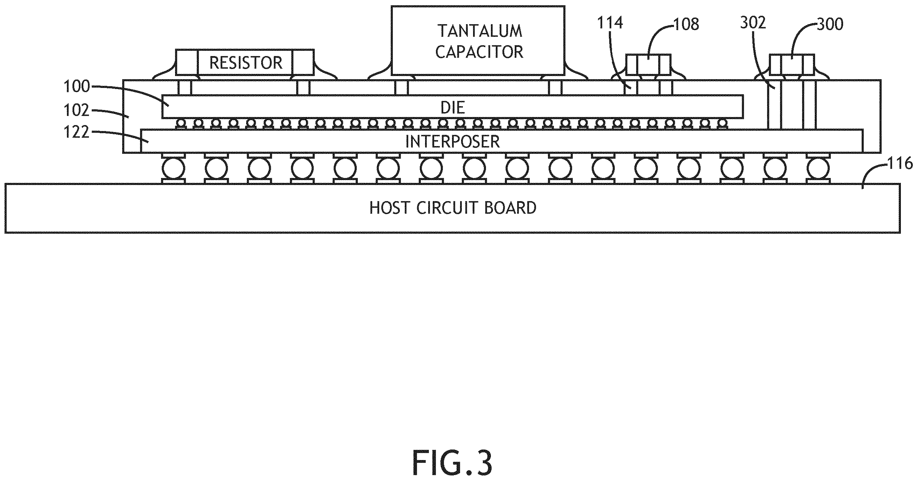

Referring to FIG. 3, a side view block diagram of a unit cell according to an exemplary embodiment is shown. The unit cell includes a die 100 contained within an over mold 102 in electronic communication with electronic components 108 disposed on a top surface of the die 100 / over mold 102. The die 100 is in electronic communication with a circuit board 116, either directly or via an interposer 122.

In at least one embodiment, one or more electronic components 300 may be disposed on the over mold 102, and be in direct electronic communication with the interposer 122 via corresponding vias 302. In such embodiments, the over mold 102 may encompass some or all of the interposer 122 as well as the die 100.

Embodiments of the present disclosure enable methods to shrink the size of the unit cell to allow higher frequency operation. Components are disposed vertically and connected through solder pads and / or vias to a die such that the components can be mounted through standard soldering techniques. Pads are disposed on both the top and the bottom side of the die for low inductance paths. Discrete components could be active components or passive components. Embodiments increase functional density to facilitate higher frequencies in an antenna.

Electronic components disposed on a top surface of the die are exposed (not molded into the package) and can be tuned / changed. Embodiments utilize a combination of through wafer vias and through package vias. AESA printed circuit boards can have dozens or hundreds of expensive electronic components; reworking electronic components on the host AESA board may reduce the quantity of scrap.

Embodiments of the present disclosure may be applicable to analog or digital electronic components in a vertical stack. Manufacturing processes may produce a smaller footprint, higher component density, higher yield, and lower HF interference.

It is believed that the inventive concepts disclosed herein and many of their attendant advantages will be understood by the foregoing description of embodiments of the inventive concepts, and it will be apparent that various changes may be made in the form, construction, and arrangement of the components thereof without departing from the broad scope of the inventive concepts disclosed herein or without sacrificing all of their material advantages; and individual features from various embodiments may be combined to arrive at other embodiments. The forms herein before described being merely explanatory embodiments thereof, it is the intention of the following claims to encompass and include such changes. Furthermore, any of the features disclosed in relation to any of the individual embodiments may be incorporated into any other embodiment.

## Claims

1. An electronic package comprising:
a die (100);
an over mold surrounding the die (100); and
a plurality of vias transiting a top surface of the over mold, disposed to engage electronic components on the top surface and produce electronic connectivity to a top surface of the die (100),
wherein a bottom surface of the die (100) is configured for electronic connectivity to an interposer or circuit board.

2. The electronic package of Claim 1, wherein the electronic package comprises one of a lead frame package, a wafer level chip scale package "WLCSP", or a wafer level fanout package "WLFO".

3. The electronic package of Claim 1 or 2, further comprising an interposer, wherein the die (100) and over mold are disposed on a top surface of the interposer and the over mold at least partially encloses the interposer.

4. The electronic package of Claim 3, further comprising one or more vias disposed to provide electronic connectivity between the top surface of the over mold and the top surface of the interposer without engaging the die (100).

5. The electronic package of any preceding Claim, further comprising one or more electronic components disposed on the top surface of the over mold, each in electronic communication with at least one of the plurality of vias.

6. The electronic package of Claim 5, wherein the electronic components are tunable.

7. An antenna comprising:
a. a plurality of unit cells, each unit cell comprising:
i. a die (100);
ii. an over mold surrounding the die (100); and
iii. a plurality of vias transiting a top surface of the over mold, disposed to engage electronic components on the top surface and produce electronic connectivity to a top surface of the die (100),
b. wherein a bottom surface of the die (100) is configured for electronic connectivity to an interposer or circuit board.

8. The antenna of Claim 7, wherein unit cell comprises one of a lead frame package, a wafer level chip scale package "WLCSP", or a wafer level fanout package "WLFO".

9. The antenna of Claim 7 or 8, further comprising a circuit board, wherein:
a. each unit cell is disposed on a top surface of the circuit board.

10. The antenna of Claim 7, 8 or 9, further comprising an interposer, wherein the die (100) and over mold are disposed on a top surface of the interposer and the over mold at least partially encloses the interposer, and optionally further comprising one or more vias disposed to provide electronic connectivity between the top surface of the over mold and the top surface of the interposer without engaging the die (100).

11. The antenna of Claim 7, 8, 9 or 10, further comprising one or more electronic components disposed on the top surface of the over mold, each in electronic communication with at least one of the plurality of vias, and optionally wherein the electronic components are tunable.

12. A system comprising:
a. an antenna having a plurality of unit cells, each unit cell comprising:
i. a die (100);
ii. an over mold surrounding the die (100); and
iii. a plurality of vias transiting a top surface of the over mold, disposed to engage electronic components on the top surface and produce electronic connectivity to a top surface of the die (100),
b. wherein a bottom surface of the die (100) is configured for electronic connectivity to an interposer or circuit board.

13. The system of Claim 12, wherein each unit cell comprises one of a lead frame package, a wafer level chip scale package "WLCSP", or a wafer level fanout package "WLFO".

14. The system of Claim 12 or 13, further comprising a circuit board, wherein:
a. each unit cell is disposed on a top surface of the circuit board.

15. The system of any of Claims 12 to 14, further comprising an interposer, wherein the die (100) and over mold are disposed on a top surface of the interposer and the over mold at least partially encloses the interposer, and optionally further comprising one or more vias disposed to provide electronic connectivity between the top surface of the over mold and the top surface of the interposer without engaging the die (100), or further comprising one or more electronic components disposed on the top surface of the over mold, each in electronic communication with at least one of the plurality of vias, and optionally wherein the electronic components are tunable.
